# EUROPEAN PATENT SPECIFICATION

(11) **EP 2 615 898 B1**
(45) Date of publication and mention of the grant of the patent: **19.03.2014**
(21) Application number: 12192201.7
(22) Date of filing: 12.11.2012
(51) Int. Cl.: H05K 7/20, B60R 16/02

(54) **Vehicle heat release structure**
Struktur zur Freisetzung von Fahrzeugwärme
Structure de libération de chaleur de véhicule

(30) Priority: 12.01.2012 JP 2012003945
(43) Date of publication of application: 17.07.2013
(73) Proprietor: Sumitomo Wiring Systems, Ltd., Yokkaichi-city, Mie 510-8503 (JP)
(72) Inventor: Imada, Yasunori, Yokkaichi-city, Mie 510-8503 (JP)
(74) Representative: Winter, Brandl, Fürniss, Hübner, Röss, Kaiser, Polte - Partnerschaft

(56) References cited:
- US-A- 5 856 909

## Description

The present invention relates to a heat release structure for a vehicle supplying a heat releasing effect to a predetermined heat generator housed within a housing unit such as an ECU (Electronic Control Unit), a junction block (J/B), or the like provided in a predetermined cabin exterior region, such as a vehicle's engine compartment.

Housing units (blocks) such as a junction block or an ECU are generally provided to an engine compartment (vehicle exterior region in an automobile). Ordinarily, these housing units are electrically connected to an exterior via a wire harness.

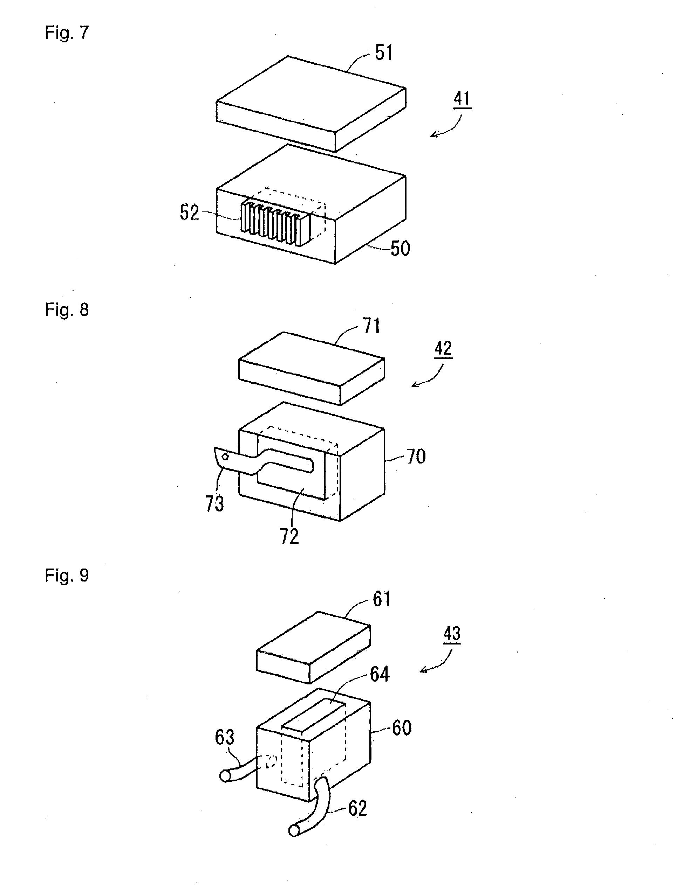

In addition to ambient temperature within the engine compartment (cabin exterior region), these housing units include on an interior thereof components constituting heat generators generating heat by electric conductivity. Many components constituting heat generators require strategies for releasing heat. Hereafter and with reference to Figs. 7 to 9 of the accompanying drawings, first through third heat release strategies, performed as conventional heat release strategies, are described.

### <First Heat Release Strategy>

Fig. 7 is an explanatory diagram showing a first conventional heat release strategy for a junction block 41. As shown in the figure, in the junction block 41 components (such as a relay, a fuse, a circuit breaker, or the like, which are not shown in the drawing) which may constitute heat generators are placed within a housing case 50. The above-noted components are housed by providing a lid 51. In addition, a heat releasing fin 52 is provided running from an interior of the housing case 50 to an exterior on a lateral surface. Through contact with outside air, the heat releasing fin 52 supplies a heat release strategy for heat generated by the interior components. An example of a heat release structure with this kind of heat releasing fin 52 (heat sink) is a casing with a built-in circuit board, as disclosed in JP 2007-109993 A.

### <Second Heat Release Strategy>

Fig. 8 is an explanatory diagram showing a second conventional heat release strategy for a junction block 42. As shown in the figure, in the junction block 42 components (such as a relay, a fuse, a circuit breaker, or the like, which are not shown in the drawing) which may constitute heat generators are placed within a housing case 70. The above-noted components are housed by providing a lid 71. Moreover, a panel connector 72 constituting a heat transfer sheet is provided running from an interior of the housing case 70 to an exterior on a lateral surface. A heat releasing panel 73 having a step portion 73a on an end side is provided on an exterior exposed surface of the panel connector 72. The two surfaces of the step portion 73a form a contact surface area with the outside air, and thus the heat releasing panel 73 carries out a strategy for releasing heat generated by the interior components via the heat releasing panel 73 and the panel connector 72.

### <Third Heat Release Strategy>

Fig. 9 is an explanatory diagram showing a third conventional heat release strategy for an ECU 43. As shown in the figure, in the ECU 43 a heat generating block 64 including computer chips, for example, is placed within a housing case 60. The heat generating block 64 is housed by providing a lid 61. Moreover, a cooling pipe 62 and a cooling pipe 63 having comparatively large diameters are provided on one lateral surface and another lateral surface of the housing case 60. Air from a separately-provided, dedicated cooling fan (not depicted) is forced in through the cooling pipe 62 and then forced out through the cooling pipe 63. By performing an air cooling process of this kind by drawing heat, a heat release strategy is performed for heat generated by the heat generating block 64. In addition, a cooling fan is provided, for example, to the engine compartment (cabin exterior region). Such a heat release structure is disclosed in US 5 856 909 A.

However, the first and second conventional heat releasing strategies described above achieve a heat releasing effect through contact with outside air by a dedicated heat releasing component (the heat releasing fin 52, the heat releasing panel 73, and the like), and are therefore problematic in that costs increase accordingly.

Moreover, the above-described heat-releasing components must be made large enough to absolutely ensure a contact surface area necessary for heat release and, in addition, must avoid interfering with other exterior components when put in place. Accordingly, the first and second heat releasing strategies are problematic as regards the size and placement of heat releasing components, in that limitations on vehicle mounting are significant.

The third conventional heat release strategy described above requires that a dedicated cooling fan and the cooling pipes 62 and 63 having comparatively large diameters be provided as dedicated heat releasing components. The third conventional heat release strategy is therefore problematic in that a configuration of the heat release structure becomes complicated and costs more.

The present invention is conceived to resolve the above issues and has as an object to obtain, with a simple configuration and without inviting limitations on vehicle mounting, a heat release structure for a vehicle capable of a heat release strategy for a heat generator.

Solution of this object is achieved by what is claimed in claim1, wherein the aspects of the subclaims contain advantageous modifications of the invention.

Accordingly, the heat release structure for a vehicle according to the present invention is a heat release structure for a vehicle for an electronic type heat generator provided in a cabin exterior region of the vehicle. The heat release structure includes a wire harness positioned so as to run from the cabin exterior region to a cabin interior and a heat releasing hose having a first end portion, a main portion, and a second end portion in which the main portion is integrally mounted in the wire harness. The first end portion of the heat releasing hose is positioned within the cabin exterior region and the second end portion of the heat releasing hose is positioned in the cabin interior. Thereby, when a predetermined condition for the vehicle is satisfied, heated air in a vicinity of the heat generator can be taken in by the first end portion, pass through the main portion, and then be expelled to the cabin interior by the second end portion.

Preferably and according to a further (second) aspect of the invention, the predetermined condition includes an air pressure differential arising between the cabin interior and the vehicle exterior region due to air pressure inside the cabin becoming lower than that of the vehicle exterior region.

Preferably and according to an other (third) aspect of the invention, the cabin interior includes an air conditioned region having an air conditioner. The air conditioner has a cabin interior air intake ability, taking in air of the cabin interior via an intake hose while active. The second end portion can be connected so as to flow into a middle portion of the intake hose. The predetermined condition includes a case where the air conditioner is active.

Preferably and according to a still further (fourth) aspect of the invention, the heat generator includes a heat generator housed within a housing unit. The heat release structure for the vehicle further includes an auxiliary hose in which a first terminus is positioned adjacent to the heat generator inside the housing unit and a second terminus is positioned outside the housing unit. The first end portion is connected to the second terminus of the auxiliary hose such that heated air can flow therethrough.

The heat release structure for the vehicle further includes - according to an other (fifth) aspect of the invention - a wire harness connection provided at a foremost end of the at least one bundle of electric wires and a unit connection provided to the housing unit and capable of linking with the wire harness connection. The unit connection includes an opening capable of expelling heated air from the heat generator. The wire harness connection includes a heat releasing hose connection terminal capable of connecting to the first end portion of the heat releasing hose. When the unit connection and the wire harness connection are linked, the first end portion connected to the wire harness connection allows air within the housing unit to flow through the opening.

Preferably and according to still an other (sixth) aspect of the invention the housing unit includes an ECU.

Also preferably the housing unit may include a junction block.

The heat release structure according to the present invention is thus characterized by the intake of heated air in the vicinity of the heat generator by the first end portion and the expulsion via the main portion of the heated air to the cabin interior from the second end portion being enabled when the predetermined condition is satisfied. Therefore, when the predetermined condition is satisfied, a heat releasing effect on the heat generator is realized. In this context it is to be noted that the "heat generator" may be a heat generating unit or units of an electronic type. It may hereinafter also be regarded as a "predetermined heat generator", however thereby not restricting kind, number, exact location etc. of such a heat generator(s).

A wire harness to be positioned running from the cabin exterior region to the cabin interior is employed as the wire harness described above. Thereby, heat can be released from the (predetermined) heat generator with a comparatively simple configuration where the only structural element required in practice is the heat releasing hose, the main portion of which is integrally mounted in the wire harness. As a result, dedicated heat releasing components such as a heat releasing fin or a heat releasing fan become unnecessary, and thus a heat release structure for a vehicle can be achieved with a comparatively low-cost configuration without inviting limitations on vehicle mounting.

The heat release structure of the present invention according to the second aspect enables a heat releasing effect to be realized without providing a special heated air intake ability by employing an air pressure differential arising between the cabin interior and the vehicle exterior region while the vehicle is moving.

The present invention according to the second aspect thus enables an effective heat releasing effect with a low-cost configuration to be realized by employing an intake hose used by an air conditioner.

The first end portion of the heat releasing hose in the present invention according to the fourth aspect is connected so as to enable airflow therethrough to the second terminus of the auxiliary hose, the first terminus of which is positioned adjacent to the heat generator. Thus, a heat releasing effect can be effectively realized for the heat generator itself provided within the housing unit.

By employing a unit connection and a wire harness connection generally included in a housing unit and a wire harness, respectively, the heat release structure in the present invention according to the fifth aspect enables an effective heat releasing effect to be realized with a comparatively simple structure and in which attachment of a first end portion to the housing unit is easy.

The present invention according to the sixth and seventh aspects enables a heat releasing effect to be realized for the heat generator housed in the housing unit such as an ECU or a junction block.

The invention now will be described in detail by way of illustrative and not limiting examples and embodiments, respectively, thereof, which are to be seen in conjunction with the accompanying drawings, in which:
Fig. 1 is an explanatory diagram showing a schematic configuration of a heat release structure for a vehicle, which is embodiment 1 of the present invention;
Fig. 2 is an explanatory diagram schematically showing a hose connection structure adjacent to a first end portion of a heat releasing hose;
Fig. 3 is an explanatory diagram showing details of the heat releasing hose in each of an engine compartment interior and a cabin interior, and the vicinity thereof;
Fig. 4 is an explanatory diagram schematically showing an internal structure of a housing unit, viewing the engine compartment from a direction d1;
Fig. 5 is an explanatory diagram schematically showing a connector peripheral structure in a heat release structure for a vehicle, which is embodiment 2 of the present invention;
Fig. 6 is an explanatory diagram schematically showing an air conditioning unit periphery in the cabin interior in a heat release structure for a vehicle, which is embodiment 3 of the present invention;
Fig. 7 is an explanatory diagram showing a first conventional heat release strategy;
Fig. 8 is an explanatory diagram showing a second conventional heat release strategy; and
Fig. 9 is an explanatory diagram showing a third conventional heat release strategy.

### <Embodiment 1>

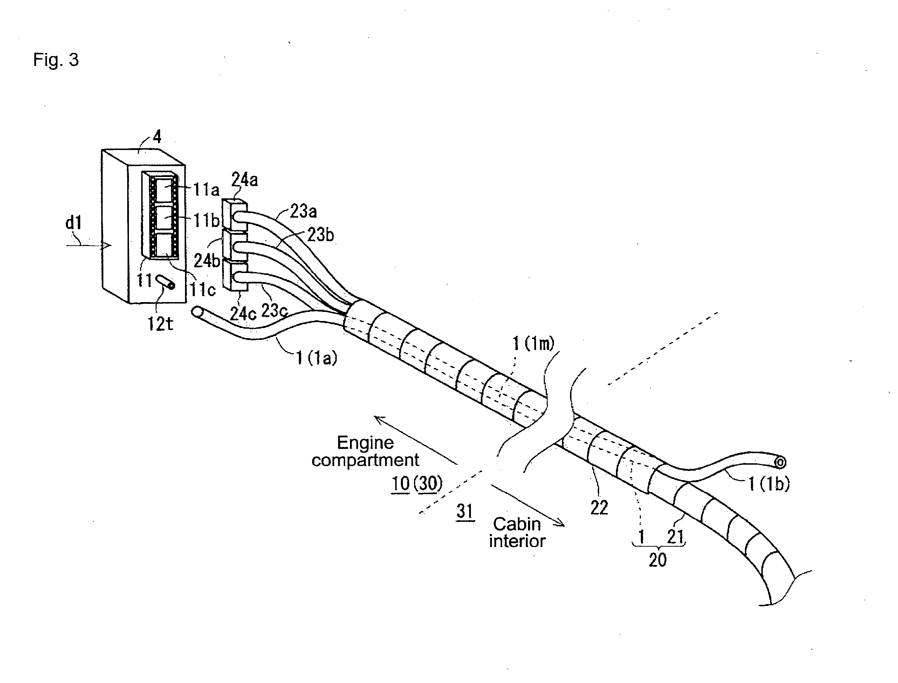

Fig. 1 is an explanatory diagram showing a schematic configuration of a heat release structure for a vehicle, which is embodiment 1 of the present invention. Fig. 2 is an explanatory diagram showing a frame view of a hose connection structure adjacent to a first end portion of a heat releasing hose.

A heat release structure for a vehicle in embodiment 1 is configured with a heat releasing hose 1 and a wire harness 21. The heat releasing hose 1 is configured with a first end portion 1 a (first end portion); a main portion 1 m (middle portion); and a second end portion 1 b (second end portion). Moreover, in the instant specification, the first end portion 1a refers to a region of a predetermined length from a foremost end on a first side of the heat releasing hose 1 and the second end portion 1 b refers to a region of a predetermined length from a foremost end on a second side of the heat releasing hose 1.

As shown in Fig. 1, the wire harness 21 is threaded from a cabin exterior 30 to a cabin interior 31. Moreover, the heat releasing hose 1 is provided by integrally mounting the main portion 1 m in the wire harness 21 in any suitable manner, such as by tape winding.

A housing unit 4 is positioned within a storage box 5 on the cabin exterior 30 in an engine compartment or the like. As shown in Fig. 2, a heat generator 4h, which is a component such as a computer chip or a relay, is housed within the housing unit 4. In addition, a first end or terminus of an auxiliary hose 12 is positioned adjacent to the heat generator 4h and a second end or terminus of the auxiliary hose 12 is positioned outside the housing unit 4 through e.g. one lateral surface.

In addition, examples of the housing unit 4 include any unit which houses a component which may constitute the heat generator 4h, such as an engine control ECU, a junction block, a relay block (R/B), an antilock brake ECU, and a fuel pump resistor.

The first end portion 1 a of the heat releasing hose 1 branches from the wire harness 21 within an engine compartment 10 and is connected with the second terminus of the auxiliary hose 12 provided to a lateral surface of the housing unit 4, the first end portion 1 a connected such that heated air in the vicinity of the heat generator 4h can pass therethrough. The second end portion 1b of the heat releasing hose 1 is positioned in a predetermined location in the cabin interior 31 (a location in the cabin interior 31 where air can be expelled).

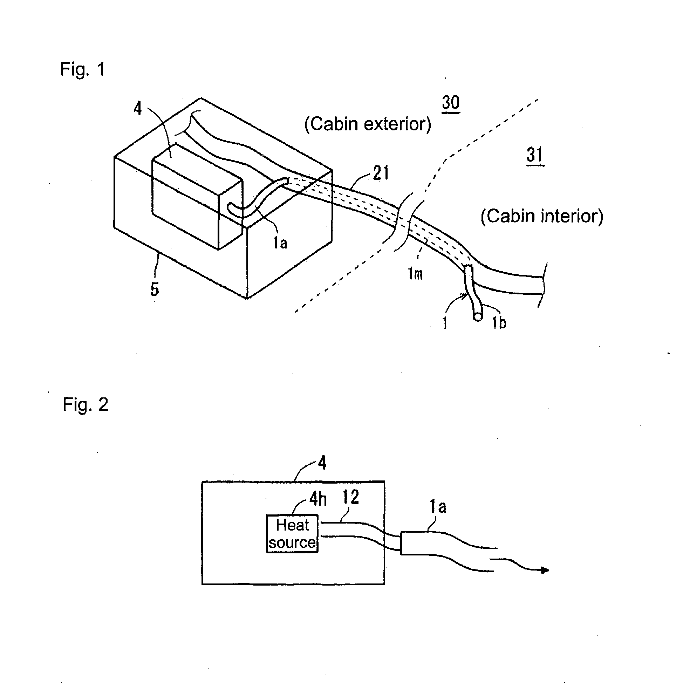

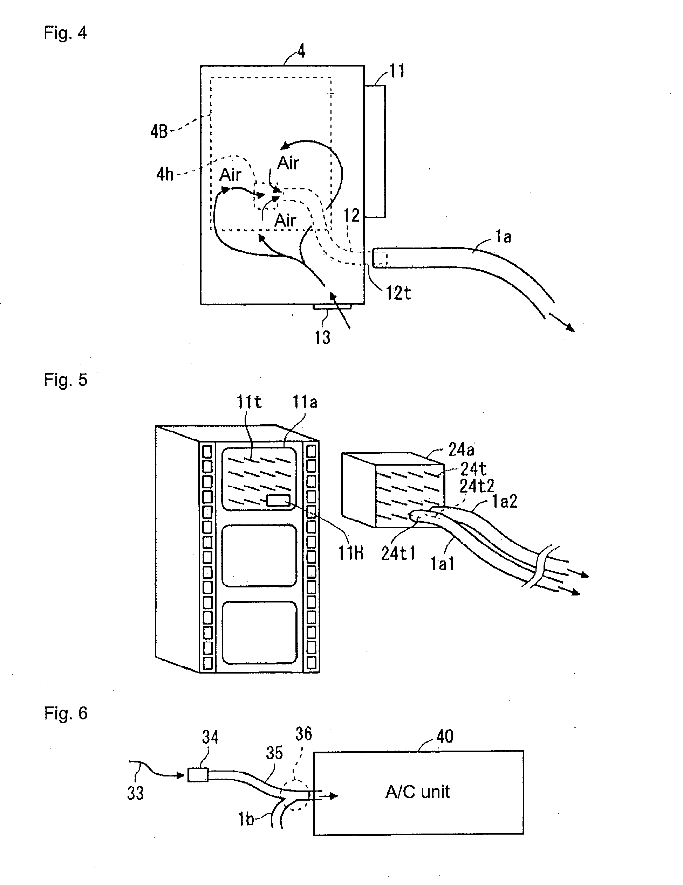

Fig. 3 is an explanatory diagram showing details of the heat releasing hose 1 in each of the engine compartment 10 interior and the cabin interior 31, and the vicinity thereof. Fig. 4 is an explanatory diagram showing a frame view of a structure, viewing the engine compartment 10 from a direction d1 in Fig. 3.

As shown in Fig. 3, the wire harness 21, in which bundles of electric wires 23a to 23c, each of which is wrapped with tape, are bundled by e.g. being further wrapped with tape, and the main portion 1 m are further wrapped with a tape 22 and are thereby integrally mounted. An integrated body 20 of the heat releasing hose 1 and the wire harness 21 is provided running from the engine compartment 10 (cabin exterior 30) to the cabin interior 31.

Within the engine compartment 10, connections 24a to 24c are provided to foremost ends of the bundles of electric wires 23a to 23c exposed from the tape 22. A connector 11 having connections 11a to 11c is provided to a lateral surface of the housing unit 4. By linking the connections 24a to 24c on the wire harness 21 with the connections 11a to 11c on the housing unit 4, the housing unit 4 is electrically connected to the bundles of electric wires 23a to 23c in the wire harness 21.

Moreover, within the engine compartment 10, the first end portion 1 a of the heat releasing hose 1 is exposed from the tape 22 and branches from the bundles of electric wires 23a to 23c. An auxiliary hose terminus 12t (the second terminus of the auxiliary hose 12) stands upright on the lateral surface of the housing unit 4. By attaching an opening on the foremost end of the first end portion 1 a to the auxiliary hose terminus 12t, a path can be provided through which heated air in the vicinity of the heat generator 4h can pass from the housing unit 4 via the auxiliary hose 12 and the heat releasing hose 1 to the second end portion 1 b in the cabin interior 31.

In the cabin interior 31, the second end portion 1 b is exposed from the tape 22 and branched from the wire harness 21 into an open state, and thus is enabled to expel air into the cabin interior 31.

As shown in Fig. 4, the heat generator 4h, which is a heat generating component such as a computer chip or a relay, is mounted on a board 4B within the housing unit 4. An air vent 13 configured by adhering a waterproof but vapour permeable fabric thereto is included on the housing unit 4, which is able to continuously take in air from the exterior. Moreover, the air vent 13 is provided so that the outside air and air pressure within the housing unit 4 are constant. In addition, the engine compartment 10, within which the housing unit 4 is provided, also includes a gap which is capable of continuously taking in air.

In such a configuration, while the vehicle is in motion, the pressure within cabin interior 31 becomes 0.1 to 0.3 atmospheres lower than in the engine compartment 10. Therefore, the heated air in the vicinity of the heat generator 4h within the housing unit 4, which is positioned within the engine compartment 10, flows out to the cabin interior 31 from the second end portion 1 b via the auxiliary hose 12 and the heat releasing hose 1. Moreover, as described above, the housing unit 4 can take air in through the outside air vent 13 and the engine compartment 10 includes a gap. Therefore, while the vehicle is moving, air continuously flows from the housing unit 4 to the cabin interior 31. Thereby, heat from the heat generator 4h within the housing unit 4 such as the ECU or the junction block can be released effectively.

In addition, the heat release structure for the vehicle of embodiment 1 takes as a predetermined condition related to the vehicle the differential air pressure arising between the cabin interior 31 and the engine compartment 10 due to the air pressure in the cabin interior 31 becoming lower than that of the engine compartment 10 (cabin exterior 30) and can realize a heat releasing effect for the heat generator 4h when the predetermined condition is satisfied. In this way, the heat release structure for the vehicle of embodiment 1 can realize a heat releasing effect without providing a separate intake ability, such as a fan, for heated air from the heat generator 4h by utilizing the air pressure differential arising between the chamber interior 31 and the engine compartment 10 that necessarily arises when the vehicle is in motion.

Moreover, the wire harness 21 is a wire harness originally intended for threading from the engine compartment 10 (the predetermined cabin exterior region) to the cabin interior 31. Therefore, the heat releasing hose 1, the main portion 1 m of which is integrally mounted to the wire harness 21, and the auxiliary hose 12 are the only structural elements required in practice for the heat release structure for the vehicle.

Additionally, by employing commonly used PVC (Polyvinyl Chloride) hoses as the heat releasing hose 1 and the auxiliary hose 12, the heat releasing hose 1 and the auxiliary hose 12 may be achieved at a comparatively low cost.

When the main portion 1 m of the heat releasing hose 1 is mounted in the wire harness 21 used for the electrical connection to the housing unit 4, the heat release structure for the vehicle of embodiment 1 can be achieved at a basic level. Therefore, a dedicated design for the heat releasing hose 1 is unnecessary and the heat release structure for the vehicle can be designed without requiring commensurate development costs.

By altering the hose diameter of the heat releasing hose 1 as appropriate, an amount of air during heat drawing (flow of heated air from the housing unit 4 to the cabin interior 31) can be altered. Therefore, tests and analysis of heat releasing effectiveness can be performed comparatively easily, and costs required for tests and analysis can accordingly be reduced.

As a result, the heat release structure for the vehicle of embodiment 1 can release heat generated by the heat generator 4h (the predetermined heat generator) with a comparatively simple structure. In other words, dedicated heat releasing components such as a heat fin and a heat releasing fan become unnecessary, and thus the heat release structure for the vehicle can be achieved with a comparatively low-cost configuration without inviting limitations on vehicle mounting.

Additionally, as described above, dedicated heat releasing components are unnecessary, and the heat release structure for the vehicle can be obtained without relying on designs for each individual dedicated heat releasing component. Therefore, the time and effort required to rework a design when there is a change in a dedicated heat releasing component is eliminated, and thus a reduction in development costs can be achieved.

Moreover, the first end portion 1 a of the heat releasing hose 1 is connected so as to enable airflow therethrough to the second terminus of the auxiliary hose 12 (auxiliary hose terminus 12t), which is an auxiliary hose in which the first terminus is positioned adjacent to the heat generator 4h. Accordingly, the heated air in the vicinity of the heat generator 4h can be taken in directly, and the heat releasing effect can be achieved that much more effectively.

Furthermore, even when a configuration does not provide an auxiliary hose 12 and simply attaches a foremost opening of the first end portion 1 a to one lateral surface of the housing unit 4, air can flow continuously from the housing unit 4 to the cabin interior 31 while the vehicle is in motion. Such a configuration is thus fully capable of achieving a heat releasing effect for the heat generator 4h within the housing unit 4. However, from a perspective of greater heat releasing effect, providing the auxiliary hose 12 is preferred.

### <Embodiment 2>

Fig. 5 is an explanatory diagram showing a frame view of connector peripheral structure of a heat release structure for a vehicle, which is embodiment 2 of the present invention.

As shown in the figure, a plurality of terminals 11t for connection with a corresponding connection 24a (connection on the wire harness) are provided on a connector 11a on the housing unit 4 side (unit connection), and an opening 11 H is provided in a region where no terminal 11t is formed. Moreover, from the perspective of heat releasing effect, similar to embodiment 1, positioning the second terminus of the auxiliary hose 12 adjacent to the opening 11H on the housing unit 4 is preferred.

As shown in the figure, the first end portion 1a in embodiment 2 is configured with two first end portions 1a1 and 1 a2. A plurality of terminals 24t are provided on the connection 24a connected to each wire in the bundle of electric wires 23a. Of these, terminals 24t1 and 24t2 are provided not for the bundle of electric wires 23a, but for the first end portions 1a1 and 1a2.

Accordingly, when a connection is made between the corresponding connection 11 a and the connection 24a, the opening 11H and the terminals 24t1 and 24t2 enter a positional relationship facing each other and, via the opening 11H and the first end portions 1a1 and 1a2, connection to the heat releasing hose 1 is made so as to enable air within the housing unit 4 to pass therethrough. Other structures are similar to the heat release structure for the vehicle of embodiment 1 shown in Figs. 1 to 4 and a description thereof is therefore omitted. In addition, as long as a connection between the opening 11H and the first end portions 1a1 and 1a2 is possible without the terminals 24t1 and 24t2, the terminals 24t1 and 24t2 may be omitted.

In such a configuration, while the vehicle is in motion, pressure within the cabin interior 31 becomes 0.1 to 0.3 atmospheres lower than in the engine compartment 10. Therefore, air within the housing unit 4 flows out to the cabin interior 31 from the second end portion 1b via the opening 11H, the first end portions 1a1 and 1 a2, and the heat releasing hose 1. Accordingly, similar to embodiment 1, heat can be effectively released from the heat generator 4h within the housing unit 4 due to air flowing continuously from the housing unit 4 to the cabin interior 31 while the vehicle is in motion, achieving an effect similar to the first embodiment.

Moreover, the heat release structure for the vehicle of embodiment 2 employs the connection 24a for the bundle of electric wires 23a and the opening 11H provided to a portion of the connection 11a on the housing unit 4. Thereby, the heat releasing hose 1, the main portion 1 m of which is integrally mounted to the wire harness 21, is essentially the only structural element required.

As a result, the heat release structure for the vehicle of embodiment 2 can release heat generated by the heat generator 4h (the predetermined heat generator) with a comparatively simple configuration.

Additionally, when electrically connecting the bundle of electric wires 23a to the housing unit 4, that is, connecting the connection 11 a and the connection 24a, the connection of the first end portions 1a1 and 1 a2 with the opening 11H can also be performed alongside. Therefore, the work of attaching the heat releasing hose 1 to the housing unit 4 can be simplified.

### <Embodiment 3>

Fig. 6 is an explanatory diagram showing a frame view of an air conditioning unit periphery in a cabin interior 31 for a heat release structure for a vehicle, which is embodiment 3 of the present invention.

Embodiments 1 and 2 have a configuration in which the second end portion 1b of the heat releasing hose 1 is placed in a predetermined location in the cabin interior 31. However, in embodiment 3, the second end portion 1 b is connected so as to flow into a sensor hose 35. This point is elaborated on below.

A cabin interior air temperature sensor 34 is provided to an air conditioning unit 40 (predetermined air conditioner). The cabin interior air temperature sensor 34 is provided at an inlet of the sensor hose 35. In order to cause the cabin interior air temperature sensor 34 to perform, cabin interior air 33 is pulled into the air conditioning unit 40 via the sensor hose 35. In other words, the air conditioning unit 40 includes a cabin interior air intake ability in which, while active, air flows continuously within the sensor hose 35 from the cabin interior air temperature sensor 34 toward the air conditioning unit 40.

Thus, the second end portion 1 b of the heat releasing hose 1 is connected so as to join a hose confluence portion 36 at a middle portion of the sensor hose 35 (the intake hose). Thereby, while the air conditioning unit 40 is active, a flow of air within the heat releasing hose 1 from the first end portion 1 a to the second end portion 1 b can be continuously generated. Moreover, other structures are similar to the heat release structure for the vehicle of embodiment 1 shown in Figs. 1 to 4, and therefore a description thereof is omitted. At this point, the connection between the first end portion 1a of the heat releasing hose 1 and the housing unit 4 may be carried out as in embodiment 2, shown in Fig. 5.

With such a configuration, while the air conditioning unit 40 is active, regardless of whether the vehicle is in motion or not, air within the housing unit 4 flows via the heat releasing hose 1 from the second end portion 1 b to the air conditioning unit 40 in the cabin interior 31. Accordingly, while the air conditioning unit 40 is active, air flows continuously from the housing unit 4 to the cabin interior 31, and thus heat from the heat generator 4h within the housing unit 4 can be effectively released.

Moreover, in the heat release structure for the vehicle of embodiment 3, the heat releasing hose 1 is connected so as to join the sensor hose 35 of the air conditioning unit 40, and thus the heat releasing hose 1, the main portion 1 m of which is integrally mounted to the wire harness 21, is essentially the only structural element required. In other words, embodiment 3 is a case where a predetermined condition for a vehicle capable of achieving a heat releasing effect is that the air conditioning unit 40 be active.

As a result, the heat release structure for the vehicle of embodiment 3 achieves an effect in which heat generated by the heat generator 4h (the predetermined heat generator) is released with a comparatively simple structure.

### <List of essential reference numerals>

- 1: Heat releasing hose
- 1a: First end
- 1b: Second end
- 1m: Main portion
- 4: Housing unit
- 4h: Heat generator
- 10: Engine compartment
- 11a to 11c: Connection
- 11t: Terminal
- 11H: Opening
- 12: Auxiliary hose
- 20: Integrated body
- 21: Wire harness
- 23a to 23c: Bundle of electric wires
- 24a to 24c: Connection
- 40: Air conditioning unit
- 34: Cabin interior air temperature sensor
- 35: Sensor hose

## Claims

1. A heat release structure for a vehicle for a heat generator (4h) provided in a cabin exterior region (30) of the vehicle, wherein the heat generator (4h) comprises an electronic type heat generator (4h) housed within a housing unit (4), the heat release structure comprising:
a heat releasing hose (1) having a first end portion (1 a), a main portion (1 m), and a second end portion (1 b), wherein the first end portion (1 a) of the heat releasing hose (1) is positioned within the cabin exterior region (30), **characterized by** further comprising:
a wire harness (21) positioned so as to run from the cabin exterior region (30) to a cabin interior (31), the main portion (1m) of the heat release hose (1) being integrally mounted in the wire harness (21), wherein
the second end portion (1 b) of the heat releasing hose (1) is positioned in the cabin interior (31), and thereby, when a predetermined condition for the vehicle is satisfied, heated air in a vicinity of the heat generator (4h) can be taken in by the first end portion (1a), pass through the main portion (1m), and then be expelled to the cabin interior (31) by the second end portion (1b), and wherein
the predetermined condition includes an air pressure differential arising between the cabin interior (31) and the cabin exterior region (30) due to air pressure inside the cabin becoming lower than that of the cabin exterior region (30); and
there is an auxiliary hose (12) in which a first terminus is positioned adjacent to the heat generator (4h) inside the housing unit (4) and a second terminus (12t) is positioned outside the housing unit (4), and the first end portion (1 a) is connected to the second terminus (12t) of the auxiliary hose (12) such that heated air can flow therethrough; and
there is an air vent (13) included on the housing unit (4), which is able to continuously take in air from the exterior.

2. The heat release structure for the vehicle according to claim 1, wherein the cabin interior (31) includes an air conditioned region having an air conditioner (40), the air conditioner (40) having a cabin interior air intake ability taking in air of the cabin interior (31) via an intake hose while active, and
the second end portion (1 b) can be connected so as to join a middle portion of the intake hose, and
the predetermined condition includes a case where the air conditioner (40) is active.

3. The heat release structure for the vehicle according to claim 1 or 2, wherein the wire harness (21) comprises at least one bundle of electric wires (23a - 23c), the heat release structure for the vehicle further comprises:
a wire harness connection (24a - 24c) provided at a foremost end of the at least one bundle of electric wires; and
a unit connection (11a) provided to the housing unit (4) and capable of linking with the wire harness connection, wherein
the unit connection (11a) includes an opening (11H) capable of expelling heated air from the heat generator (4h),
the wire harness connection includes a heat releasing hose connection terminal (24t1) capable of connecting to the first end portion (1a1) of the heat releasing hose (1), and
when the unit connection and the wire harness connection are linked, the first end portion (1a1) connected to the wire harness connection allows air within the housing unit (4) to flow through the opening.

4. The heat release structure for the vehicle according to claim 1 or 3, wherein the housing unit (4) comprises an ECU.

5. The heat release structure for the vehicle according to claim 1 or 3, wherein the housing unit (4) comprises a junction block.

## Patentansprüche

1. Eine Struktur zur Freisetzung von Fahrzeugwärme für einen Wärmeerzeuger (4h), der in einem Bereich (30) außerhalb des Fahrgastraums des Fahrzeugs angeordnet ist, wobei der Wärmeerzeuger (4h) einen Wärmeerzeuger (4h) vom elektronischen Typ aufweist, der in einer Gehäuseeinheit (4) aufgenommen ist, wobei die Struktur zur Freisetzung von Wärme aufweist:
einen Wärmeabführschlauch (1) mit einem ersten Endabschnitt (1a), einem Hauptabschnitt (1 m) und einem zweiten Endabschnitt (1 b), wobei der erste Endabschnitt (1 a) des Wärmeabführschlauchs (1) innerhalb des Bereichs (30) außerhalb des Fahrgastraums angeordnet ist, **dadurch gekennzeichnet, dass** sie weiterhin aufweist:
einen Kabelbaum (21), der so angeordnet ist, dass er von dem Bereich (30) außerhalb des Fahrgastraums in das Innere (31) des Fahrgastraums verläuft, wobei der Hauptabschnitt (1m) des Wärmeabführschlauchs (1) einteilig in dem Kabelbaum (21) angeordnet ist, wobei
der zweite Endabschnitt (1 b) des Wärmeabführschlauchs (1) im Inneren (31) des Fahrgastraums angeordnet ist und dadurch, dass wenn eine bestimmte Bedingung für das Fahrzeug erfüllt ist, erwärmte Luft aus dem Nahbereich des Wärmeerzeugers (4h) von dem ersten Endabschnitt (1a) aufgenommen, durch den Hauptabschnitt (1m) geführt und dann in das Innere (31) des Fahrgastraums durch den zweiten Endabschnitt (1 b) abgegeben werden kann, und wobei
die bestimmte Bedingung beinhaltet, dass eine Luftdruckdifferenz zwischen dem Innenraum (31) des Fahrgastraums und dem Bereich (30) außerhalb des Fahrgastraums dadurch auftritt, dass der Luftdruck im Inneren des Fahrgastraums niedriger als in dem Bereich (30) außerhalb des Fahrgastraums wird; und
dass es einen Hilfsschlauch (12) gibt, bei dem ein erstes Ende benachbart dem Wärmeerzeuger (4h) im Inneren der Gehäuseeinheit (4) und ein zweites Ende (12t) außerhalb der Gehäuseeinheit (4) angeordnet ist, wobei der erste Endabschnitt (1 a) mit dem zweiten Ende (12t) des Hilfsschlauchs (12) so verbunden ist, dass erwärmte Luft hierdurch strömen kann; und
dass es eine Luftöffnung (13) in der Gehäuseeinheit (4) gibt, die in der Lage ist, fortlaufend Luft von außerhalb zuzuführen.

2. Die Struktur zur Freisetzung von Fahrzeugwärme nach Anspruch 1, wobei das Innere (31) des Fahrgastraums einen klimatisierten Bereich mit einer Klimaanlage (40) beinhaltet, wobei die Klimaanlage (40) im aktiven Zustand die Möglichkeit der Luftansaugung in das Fahrgastrauminnere hat, bei der Luft in das Innere (31) des Fahrgastraums über einen Ansaugschlauch geführt wird, und
der zweite Endabschnitt (1 b) so angeschlossen werden kann, dass er mit einem mittleren Abschnitt des Ansaugschlauchs in Verbindung ist, und
die bestimmte Bedingung den Fall beinhaltet, in welchem die Klimaanlage (40) aktiv ist.

3. Die Struktur zur Freisetzung von Fahrzeugwärme nach Anspruch 1 oder 2, wobei
der Kabelbaum (21) wenigstens ein Bündel elektrischer Kabel (23a-23c) aufweist und die Struktur zur Freisetzung von Fahrzeugwärme weiterhin aufweist:
eine Kabelbaumverbindung (24a-24c), die an einem äußersten Ende des wenigstens einen Bündels elektrischer Kabel angeordnet ist; und
eine Einheitsverbindung (11a), die an der Gehäuseeinheit (4) angeordnet ist und in der Lage ist, mit der Kabelbaumverbindung in Verbindung zu treten, wobei
die Einheitsverbindung (11a) eine Öffnung (11 H) aufweist, die in der Lage ist, von dem Wärmeerzeuger (4h) kommende erwärmte Luft auszustoßen,
die Kabelbaumverbindung wenigstens einen Wärmeabführschlauchverbindungsanschluss (24t1) beinhaltet, der in der Lage ist, mit dem ersten Endabschnitt (1a1) des Wärmeabführschlauchs (1) verbunden zu werden, und
dann, wenn die Einheitsverbindung und die Kabelbaumverbindung miteinander verbunden sind, der erste Endabschnitt (1a1), der mit der Kabelbaumverbindung verbunden ist, erlaubt, dass Luft innerhalb der Gehäuseeinheit (4) durch die Öffnung strömt.

4. Die Struktur zur Freisetzung von Fahrzeugwärme nach Anspruch 1 oder 3, wobei die Gehäuseeinheit (4) eine ECU aufweist.

5. Die Struktur zur Freisetzung von Fahrzeugwärme nach Anspruch 1 oder 3, wobei die Gehäuseeinheit (4) einen Verbindungsblock aufweist.

## Revendications

1. Structure de transfert de chaleur de véhicule pour un générateur de chaleur (4h) agencé dans une zone extérieure de cabine (30) du véhicule, dans laquelle le générateur de chaleur (4h) comprend un générateur de chaleur du type électronique (4h) contenu à l'intérieur d'une unité formant boîtier (4), la structure de transfert de la chaleur comprenant :
une tuyauterie de transfert de chaleur (1) présentant une première partie d'extrémité (1a), une partie principale (1m), et une seconde partie d'extrémité (1b), dans laquelle la première partie d'extrémité (1a) de la tuyauterie de transfert de chaleur (1) est positionnée à l'intérieur de la zone extérieure de cabine (30), **caractérisée par le fait qu'**elle comprend en outre :
un faisceau de câble (21) positionné de manière à s'étendre à partir de la zone extérieure de cabine (30) vers une partie intérieure de cabine (31), la partie principale (1m) de la tuyauterie de transfert de chaleur (1) étant montée de manière unitaire sur le faisceau de câble (21), dans laquelle
la seconde partie d'extrémité (1b) de la tuyauterie de transfert de chaleur (1) est positionnée dans la partie intérieure de cabine (31), et ainsi, lorsqu'une condition prédéterminée pour le véhicule est satisfaite, de l'air chauffé à proximité du générateur de chaleur (4h) peut être prélevé par la première partie d'extrémité (1a), passer à travers la partie principale (1m), et ensuite être expulsé vers la partie intérieure de cabine (31) par la seconde partie d'extrémité (1b), et dans laquelle
la condition prédéterminée comporte l'apparition d'une pression différentielle de l'air entre la partie intérieure de cabine (31) et la zone extérieure de cabine (30) du fait qu'une pression de l'air à l'intérieur de la cabine devient inférieure à celle de la zone extérieure de cabine (30) ; et
une tuyauterie auxiliaire (12) est agencée de telle sorte qu'une première extrémité est positionnée de manière adjacente au générateur de chaleur (4h) à l'intérieur de l'unité formant boîtier (4) et une seconde extrémité (12t) est positionnée à l'extérieur de l'unité formant boîtier (4), la première partie d'extrémité (1a) étant couplée à la seconde extrémité (12t) de la tuyauterie auxiliaire (12) de telle sorte que l'air chauffé peut s'écouler à travers cette dernière ; et
une mise à l'air libre (13) qui peut prélever en continu de l'air à l'extérieur est agencée sur l'unité formant boîtier (4).

2. Structure de transfert de chaleur de véhicule selon la revendication 1, dans laquelle la partie intérieure de cabine (31) comporte une zone d'air conditionné comportant un conditionneur d'air (40), le conditionneur d'air (40) présentant une capacité d'admission d'air intérieur de cabine en prélevant de l'air dans la partie intérieure de cabine (31) par l'intermédiaire d'une tuyauterie d'admission lorsqu'il est actif, et
la seconde partie d'extrémité (1b) peut être couplée de manière à relier une partie centrale de la tuyauterie d'admission, et
la condition prédéterminée comporte un cas dans lequel le conditionneur d'air (40) est actif.

3. Structure de transfert de chaleur de véhicule selon la revendication 1 ou 2, dans laquelle
le faisceau de câble (21) comprend au moins un faisceau de câbles électriques (23a à 23c),
la structure de transfert de chaleur du véhicule comporte en outre :
un raccord de faisceau de câble (24a à 24c) agencé au niveau d'une extrémité de premier plan du ou des faisceaux de câbles électriques ; et
un raccord d'unité (11a) agencé sur l'unité formant boîtier (4) et capable de se raccorder avec le raccord de faisceau de câble, dans laquelle
le raccord d'unité (11a) comporte une ouverture (11H) capable d'expulser de l'air chauffé à partir du générateur de chaleur (4h),
le raccord de faisceau de câble comporte une borne de raccordement de tuyauterie de transfert de chaleur (24t1) pouvant être raccordée à la première partie d'extrémité (1a1) de la tuyauterie de transfert de chaleur (1), et
lorsque le raccord d'unité et le raccord de faisceau de câble sont raccordés, la première partie d'extrémité (1a1) raccordée au raccord de faisceau de câble permet à l'air à l'intérieur de l'unité formant boîtier (4) de passer à travers l'ouverture.

4. Structure de transfert de chaleur de véhicule selon la revendication 1 ou 3, dans laquelle l'unité formant boîtier (4) comprend une unité ECU.

5. Structure de transfert de chaleur de véhicule selon la revendication 1 ou 3, dans laquelle l'unité formant boîtier (4) comprend un bloc de jonction.
